# FASCICULE DE BREVET EUROPEEN

(11) **EP 1 233 422 B1**
(45) Date de publication et mention de la délivrance du brevet: **19.03.2008**
(21) Numéro de dépôt: 02290164.9
(22) Date de dépôt: 23.01.2002
(51) Int. Cl.: G11C 16/34

(54) **Procédé et dispositif de rafraîchissement de cellules de référence**
Verfahren und Vorrichtung zum Erfrischen von Referenzzellen
Method and apparatus for refreshing reference cells

(30) Priorité: 02.02.2001 FR 0101440
(43) Date de publication de la demande: 21.08.2002
(73) Titulaire: STMicroelectronics S.A., 92120 Montrouge (FR)
(72) Inventeur: Fournel, Richard, 75116 Paris (FR); Sedjai, Leila, 75116 Paris (FR)
(74) Mandataire: Bentz, Jean-Paul

(56) Documents cités:
- EP-A- 0 753 859
- EP-A- 0 987 715
- WO-A-90/12400
- US-A- 5 852 582
- US-A- 5 886 927
- US-A- 6 108 241

## Description

L'invention concerne les mémoires sous forme de circuit intégré et, plus particulièrement celles du type non-volatile qui sont connues sous les acronymes EPROM pour l'expression anglo-saxonne "Electrically Programmable Read Only Memory", EEPROM pour "Electrically Erasable and Programmable Read Only Memory" et FLASH pour une mémoire qui est effaçable par groupe de cellules de mémoire.

Dans ces mémoires non-volatiles, l'invention est relative à un procédé et à un dispositif qui permet de vérifier l'état électronique de cellules de référence utilisées pour la lecture et rafraîchir en tant que de besoin leur état électronique.

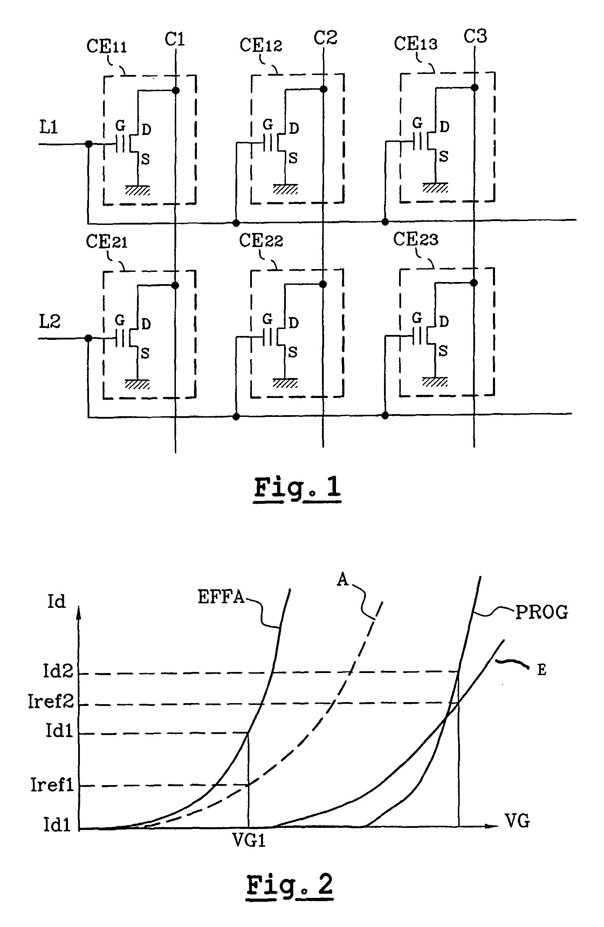

Une mémoire de type non volatile comprend une pluralité de cellules de mémoire (figure 1) CE₁₁, CE₁₂, CE₁₃, CE₂₁, CE₂₂ et CE₂₃ qui sont disposées aux intersections de lignes L1 et L2 et de colonnes C1, C2 et C3.

Chaque cellule de mémoire CE comprend un transistor MOSFET à grille isolée dont le drain D est connecté à une colonne, la source S connectée à la masse et la grille G connectée à la ligne.

Il est à noter que pour l'effacement de la cellule de mémoire, la source S est connectée à la haute tension, par exemple 12 Volts.

L'effet "mémoire" est réalisé par la charge électronique que l'on "stocke" sous la grille G, cette charge étant constituée d'électrons ou de trous. Le stockage des charges est obtenu en appliquant des tensions appropriées sur les électrodes D, S et G de chaque cellule par des circuits non representés sur la figure 1. La cellule de mémoire présente donc deux états : l'un sans charge électronique et l'autre avec charge électronique et chaque état correspond, par convention, l'un au chiffre binaire "1" et l'autre au chiffre binaire "0".

La lecture des cellules de mémoire est effectuée en appliquant d'autres tensions appropriées sur les électrodes D, S et G de chaque cellule de sorte que le signal fourni par une cellule chargée sur la colonne sera différent de celui fourni par une cellule non chargée. En comparant le signal de lecture à celui fourni par une cellule dite de référence, correspondant à une cellule non chargée, il est déterminé si la cellule de mémoire lue est chargée ou non.

Plus précisément, le courant drain/source Id (figure 2) d'une cellule de mémoire varie en fonction de la tension VG appliquée sur la grille G selon la courbe EFFA dans l'état effacé ou sans charge et selon la courbe PROG dans l'état chargé ou programmé. La courbe A en pointillés est celle de la cellule de référence et correspond à celle d'une cellule de mémoire non chargée mais dont le signal de sortie est appliqué à un amplificateur de gain inférieur à l'unité.

Lors d'une opération de lecture, on applique une tension de grille VG1, comprise entre les deux courbes EFFA et PROG et l'on mesure le courant Id1 de la cellule CE et le courant Iref de la cellule de référence :
- si Id1 est inférieur à Iref1, la cellule mémoire est à l'état chargé ou programmé(courbe PROG) ;
- si Id1 est supérieur à Iref1, la cellule mémoire est à l'état sans charge ou effacé (courbe EFFA).

Les cellules de référence sont réalisées sous la forme d'une colonne supplémentaire REF de la mémoire de sorte qu'une cellule de référence est sollicitée à chaque lecture d'une cellule de mémoire de la ligne.

Cette sollicitation a pour effet que la cellule de référence a tendance à se charger à chaque fois de sorte que sa courbe caractéristique se déplace vers la courbe PROG. Lorsque ce déplacement est trop important (courbe E), il en résulte une erreur de lecture car la cellule chargée fournira un courant Id2 supérieur au courant Iref2 et sera considérée comme étant dans l'état effacé alors qu'elle est à l'état chargé (PROG).

Cette erreur peut se manifester après un laps de temps plus ou moins long selon les caractéristiques de la cellule de référence et le nombre de fois que cette dernière est sollicitée.

On connaît du document WO-A-90 12400 une mémoire comportant des cellules de référence dédiées à des secteurs, et qui peuvent être reprogrammées selon un algorithme spécifique, faisant appel à une cellule de référence maîtresse. Par exemple, pour reprogrammer les cellules de référence à l'état effacé, toutes celles-ci sont lues et leur signal est comparé à celui de la cellule maîtresse pour vérifier qu'elles sont bien toutes à l'état effacé. S'il est constaté qu'au moins une des cellules de référence n'est pas à l'état effacé, une impulsion d'effacement est appliquée à toutes les cellules de référence, et la vérification que chacune d'elle est effacée est répétée. Ce processus est appliqué de manière cyclique jusqu'à ce qu'il soit vérifié que chaque cellule de référence est bien effacée.

Ensuite, l'algorithme applique une impulsion d'inscription aux cellules de référence, et vérifie de manière analogue qu'elles sont bien positionnées à l'état d'inscription. Pour celles d'entre elles qui ne sont pas à l'état inscrit, une nouvelle impulsion d'inscription est appliquée, et ce jusqu'à ce qu'elles soient toutes inscrites.

Un but de la présente invention est donc de mettre en oeuvre un procédé et de réaliser un dispositif dans une mémoire non-volatile qui permet d'éviter les erreurs de lecture dues à un changement des caractéristiques ou dérive de la cellule de référence.

Ce but est atteint en "rafraîchissant" l'état électronique des cellules de référence de premier degré lorsque leur dérive dépasse un certain seuil déterminé par une ou plusieurs autres cellule(s) de référence (2ème degré) prévue(s) à cet effet.

Cette ou ces autres cellules de référence (au 2ème degré) peuvent aussi être rafraîchies lorsque leur dérive dépasse un autre seuil déterminé par une autre (ou plusieurs autres) cellule de référence (3ème degré).

Ce procédé ou ce dispositif selon l'invention est mis en oeuvre de manière récurrente, par exemple à intervalles de temps réguliers, par exemple tous les ans, ou après un certain nombre d'opérations de lecture de la mémoire.

Le rafraîchissement des cellules de référence peut être réalisé de différentes manières, soit par leur effacement, soit par un décalage de leur courbe caractéristique, soit encore par modification du gain de l'amplificateur de lecture.

L'invention concerne donc un procédé de rafraîchissement d'au moins une cellule de mémoire de référence dans une mémoire de type non volatile, ladite cellule de référence présentant une courbe caractéristique qui correspond à une courbe caractéristique d'une cellule de mémoire dite "effacée" mais décalée vers la courbe caractéristique d'une cellule de mémoire dite "programmée",
caractérisé en ce qu'il comprend les étapes suivantes consistant à :
(a) choisir, en tant que cellule de vérification, au moins une première cellule dans l'état d'effacement de la mémoire et positionner sa courbe caractéristique entre celle de la cellule de référence et celle d'une cellule "programmée",
(b) sélectionner simultanément à la lecture une cellule de référence et la cellule de vérification,
(c) comparer les signaux provenant de la cellule de référence et de la cellule de vérification lus lors de l'étape (b), et
(d) fournir un signal de rafraîchissement de la cellule de référence sélectionnée lorsque le signal lu sur cette dernière est inférieur au signal lu sur la cellule de vérification.

Dans le cas de plusieurs cellules de référence à rafraîchir, l'étape (d) est suivie d'une étape suivante :
(e) retourner à l'étape (b) pour une autre cellule de référence.

Le signal de rafraîchissement peut agir sur la courbe caractéristique de la cellule de référence de différentes manières :
- soit en l'effaçant,
- soit en effectuant un décalage en tension de la cellule de référence,
- soit en modifiant le gain de l'amplificateur de lecture de la cellule de référence sélectionnée.

L'invention concerne également un dispositif de rafraîchissement d'au moins une cellule de mémoire de référence dans une mémoire de type non volatile, ladite cellule de référence présentant une courbe caractéristique qui correspond à une courbe caractéristique d'une cellule de mémoire dite "effacée" mais décalée vers la courbe caractéristique d'une cellule de mémoire dite "programmée",
caractérisé en ce qu'il comprend :
- des moyens pour choisir, en tant que cellule de vérification, une cellule de mémoire dans l'état d'effacement et la positionner selon une courbe caractéristique disposée entre celle de la cellule de référence et celle d'une cellule programmée,
- des moyens pour sélectionner simultanément à la lecture une cellule de référence et la cellule de vérification,
- des moyens pour comparer les signaux provenant de la cellule de référence et de la cellule de vérification lus sur la cellule de référence et la cellule de vérification, et fournir un signal de rafraîchissement de la cellule de référence lorsque le signal lu sur la cellule de référence est inférieur au signal lu sur la cellule de vérification, et
- des moyens pour modifier, en présence d'un signal de rafraîchissement, la courbe caractéristique de la cellule de référence afin de la remettre substantiellement dans l'état initial.

D'autres caractéristiques et avantages de la présente invention apparaîtront à la lecture de la description suivante d'exemples particuliers de réalisation, ladite description étant faite en relation avec les dessins joints dans lesquels :
- la figure 1 est un schéma d'une partie de mémoire non-volatile à laquelle s'applique la présente invention,
- la figure 2 est un diagramme de courbes caractérisant les états des cellules de mémoire et de référence,
- la figure 3 est un schéma d'une mémoire de type non volatile à laquelle l'invention s'applique et mettant en oeuvre le dispositif et le procédé selon l'invention,
- la figure 4 est un diagramme de courbes caractérisant les états des cellules effacées, programmées, de référence et de vérification dans le cas d'un dispositif de lecture à modification de gain du signal lu sur la cellule de référence et celle de vérification, le recalage étant effectué par effacement de la cellule de référence.
- la figure 5 est un diagramme de courbes caractérisant les états des cellules effacées, programmées, de référence et de vérification dans le cas d'un dispositif à décalage de tension,
- la figure 6 est un diagramme de courbes caractérisant les états des cellules effacées, programmées et de référence dans le cas d'un dispositif à modification de gain de la cellule de référence, et
- la figure 7 est un schéma simplifié d'un exemple particulier de réalisation des dispositifs selon l'invention.

Une mémoire non volatile 10 à laquelle s'applique l'invention comprend n x r cellules de mémoire CE disposées chacune à une intersection d'une ligne L1 à Ln et d'une colonne C1 à Cr conformément au schéma de la figure 1.

La sélection d'une cellule de mémoire s'effectue par une sélection d'une ligne et d'une colonne via des circuits d'adressage 12 pour les lignes et 14 pour les colonnes, les tensions de sélection étant fournies par des circuits d'alimentation 16 et 18 et ayant des valeurs appropriées pour réaliser l'opération envisagée telle qu'un enregistrement ou une lecture d'un chiffre binaire.

Les opérations à effectuer sur la mémoire sont commandées par un circuit de commande 24 tel qu'un microprocesseur ou microcontrôleur.

En plus des r colonnes, la mémoire comprend au moins une colonne supplémentaire REF présentant n cellules de référence Cref, de Cref1 à Crfn, une par ligne qui sert de référence lors de la lecture comme expliqué dans le préambule en relation avec la figure 2.

Le dispositif selon l'invention comprend au moins une cellule de mémoire supplémentaire Cveri qui sert de référence aux cellules de mémoire de référence Cref afin de déterminer la dérive de ces dernières par rapport à leur état initial.

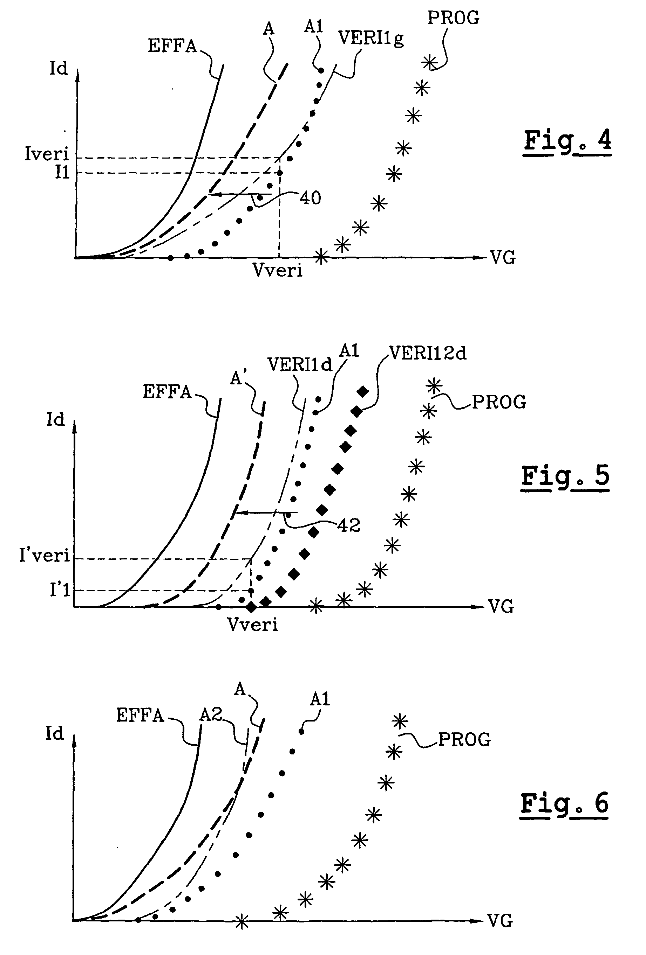

Pour servir de référence, la cellule de mémoire Cveri doit être mise dans le même état initial qu'une cellule de référence de lecture, c'est-à-dire dans l'état d'effacement (courbe EFFA). En outre, la courbe caractéristique (figure 2) doit être décalée vers celle correspondant à l'état programmé au-delà de la courbe A, soit par un choix approprié d'une valeur de gain de l'amplificateur de lecture pour obtenir une courbe VERI1g située entre la courbe A et la courbe PROG (figure 4), soit par un décalage du "pied" ou "zéro" de la courbe, sans changer la pente, pour obtenir une courbe VERI1d située entre une courbe A' de cellule de référence de lecture et la courbe PROG (figure 5).

Dans le cas de la figure 4, la cellule de mémoire Cveri est une cellule de mémoire effacée dont la courbe caractéristique est modifiée en modifiant le gain de l'amplificateur de lecture de manière à obtenir la courbe VERI1g qui correspond à un gain inférieur à celui appliqué au signal lu sur la cellule de référence Cref.

Au fur et à mesure des lectures, la cellule de référence Cref se charge et sa courbe caractéristique A1 vient à couper la courbe VERI1g de la cellule de vérification.

Il est alors considéré que la cellule de référence a trop dérivé et qu'il est nécessaire de la recaler.

A cet effet, l'invention prévoit d'effectuer une lecture de chaque cellule de référence Cref1 à Crefn et de comparer le signal lu à celui lu sur la cellule de vérification Cveri, les lectures étant effectuées à la tension de grille Vveri.

Dans le cas de la figure 4, si le courant I1 de la cellule de référence est inférieur au courant Iveri de la cellule de vérification, ou en déduit que la cellule de référence est trop chargée et qu'il est nécessaire de l'effacer pour que sa courbe caractéristique revienne en A. Dans le cas contraire, la cellule Cref est laissée en l'état.

Dans le cas de la figure 5, si le courant I'1 de la cellule de référence est inférieur au courant I'veri de la cellule de vérification, ou en déduit que la cellule de référence est trop chargée et qu'il est nécessaire de recaler sa courbe caractéristique en direction de la courbe EFFA pour la placer au voisinage de la courbe A' en appliquant une tension correctrice de recalage. Dans le cas contraire, la cellule Cref est laissée en l'état.

Il existe une troisième solution de recalage en agissant sur le gain de l'amplificateur de lecture qui sera expliqué en relation avec les courbes de la figure 6, figure qui est similaire à celle de la figure 4.

Après un certain laps de temps, la courbe de la cellule de référence dérive vers la courbe PROG pour devenir A1. Cette courbe A1 correspond à un certain gain de l'amplificateur de lecture qui est par exemple moitié de celui de la cellule mémoire. La solution proposée consiste à modifier le gain de l'amplificateur de lecture de la cellule de référence pour le rendre égal à celui d'une cellule de lecture. On obtient ainsi la courbe A2 qui correspond à celle d'une cellule de mémoire effacée mais décalée vers le droite de la figure 6.

Les deux premières solutions décrites ci-dessus sont mises en oeuvre par deux dispositifs qui comprennent chacun :
- un circuit de détection de la dérive de la cellule de référence, et
- un circuit de recalage de la cellule de référence.

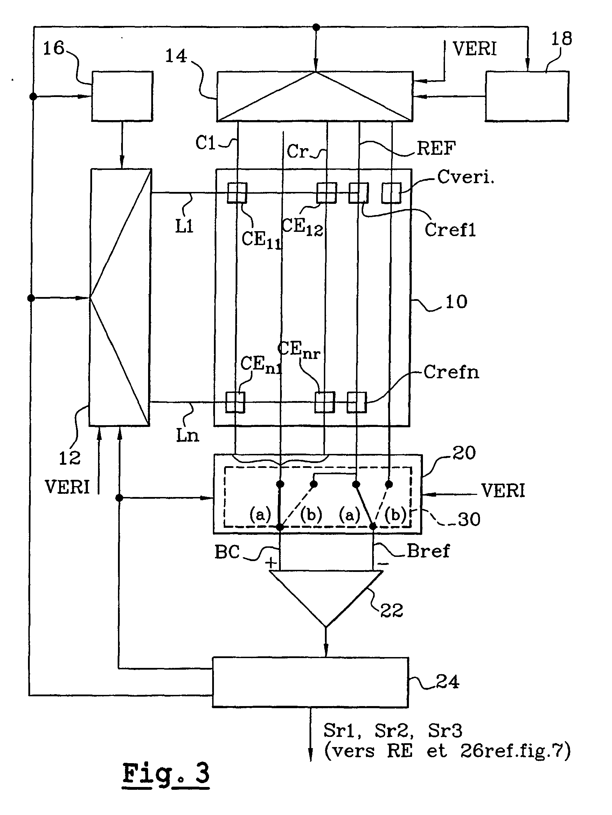

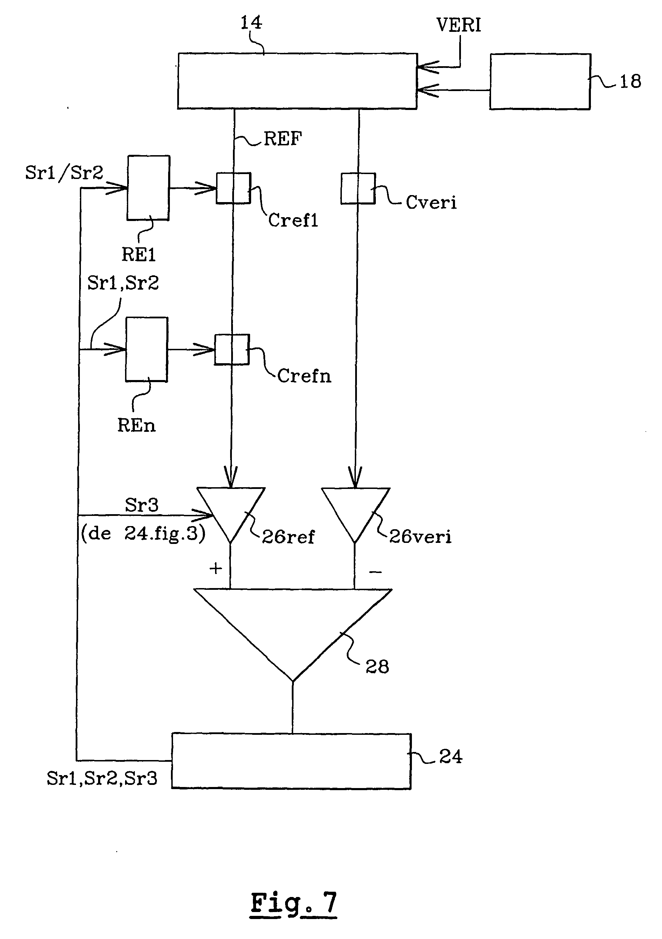

Le circuit de détection (figures 3 et 7) comprend au moins une cellule de mémoire Cveri qui est sélectionnée à la lecture par un signal VERI appliqué aux circuits de sélection de colonne 14, 18. Le signal lu sur la cellule Cveri est appliqué à une borne d'entrée Bref d'un comparateur 28 par l'intermédiaire d'un amplificateur 26veri.

Le signal lu sur la cellule de référence de lecture sélectionnée par le circuit d'adressage 12, 16 est appliqué à l'autre borne d'entrée BC du comparateur 28 par l'intermédiaire d'un amplificateur 26ref.

En pratique, le comparateur 28 est réalisé par le comparateur 22 du schéma de la figure 3 et, à cet effet, il est prévu un commutateur 30 pour aiguiller les signaux lus sur les cellules de mémoire vers les bornes d'entrée appropriées.

Dans la position (a), la borne d'entrée BC est connectée aux r colonnes tandis que la borne d'entrée Bref est connectée à la colonne de référence REF. Dans la position(b), la borne d'entrée BC est connectée à la colonne REF tandis que la borne d'entrée Bref est connectée à la cellule Cveri.

Le signal Sr1 (première solution) ou Sr2 (deuxième solution) sur la borne de sortie du comparateur 28 est appliqué sur la cellule de référence sélectionnée par l'intermédiaire d'un circuit de recalage RE1 à REn.

Le signal de sortie du comparateur 28 passe dans un certain état lorsque I1 ou I'1 est inférieur respectivement à Iveri et I'veri, ce qui signifie que la dérive a dépassé le seuil. Le comparateur reste dans l'autre état dans le cas contraire.

Dans la première solution, le circuit RE effectue un effacement de la cellule de référence en appliquant les tensions appropriées sur les électrodes de drain, source et grille, de manière que la courbe revienne en A (figure 4, flèche 40).

Dans la deuxième solution, le circuit RE effectue un décalage en tension de la source du transistor de la cellule de mémoire, ce qui déplace la courbe caractéristique vers celle correspondant à l'effacement pour le replacer au voisinage de A' (figure 5, flèche 42).

Dans la première solution, la fonction du circuit RE est de préférence mise en oeuvre via le microcontrôleur 24 qui réalise une opération d'effacement.

Dans la deuxième solution, la source S de chaque cellule de référence est connectée à une source de tension qui réalise le décalage de la courbe A'. Lorsque cette courbe arrive en A'1, le circuit RE court-circuite la source de tension de sorte que la courbe revient en A' lorsque le court-circuit est enlevé.

Dans la troisième solution, il n'y a pas de circuit RE par cellule de référence Cref mais une modification du gain de l'amplificateur de lecture 26ref associé à la colonne REF pour passer de la courbe A1 à la courbe A2 (figure 6).

La modification du gain consiste à obtenir un gain égal à l'unité au lieu qu'il soit inférieur à l'unité pour obtenir la courbe A (figure 6).

Cette modification du gain n'intervient que si toutes les cellules de référence Cref ont "dérivé" au-delà de la limite fixée par la courbe A1.

Il est donc prévu de tester chaque cellule de référence Cref et de n'effectuer la modification de gain de l'amplificateur 26ref que si toutes les cellules ont dérivé au-delà de la limite fixée.

A cet effet, le microcontrôleur 24 compte les cellules de référence qui ont dérivé au-delà de la limite fixée : si le nombre obtenu est égal à n, il y a modification du gain de l'amplificateur 26ref ; dans le cas contraire, il n'y a pas de modification.

A titre de variante, la vérification est arrêtée, et donc pas de modification de gain, dès qu'une cellule de référence n'a pas dépassé la limite fixée sans attendre la vérification des n cellules de référence.

Dans les figures 3 et 7, cette troisième solution est schématiquement représentée par le signal Sr3 fourni par le microcontrôleur 24 du schéma de la figure 3 qui est appliqué à l'amplificateur.

Le cycle de rafraîchissement des cellules de référence Cref est initialisé soit à intervalles de temps réguliers au cours de l'utilisation de la mémoire 10, par exemple une fois par an, soit après le comptage d'un certain nombre de cycles d'adressage de la mémoire 10.

Cette initialisation est effectuée par le microcontrôleur 24 qui comprend une horloge interne de mesure du temps ou un compteur de cycles de la mémoire. L'invention a été décrite en utilisant une seule cellule de vérification mais elle s'applique aussi à l'utilisation de plusieurs cellules de vérification, par exemple une par secteur de mémoire bien identifié.

L'invention s'applique également au rafraîchissement de plusieurs cellules de vérification en utilisant une autre cellule de vérification à titre de référence.

## Revendications

1. Procédé de rafraîchissement d'au moins une cellule de mémoire de référence (Cref) dans une mémoire de type non volatile (10), ladite cellule de référence (Cref) présentant une courbe caractéristique (A, A') qui correspond à une courbe caractéristique d'une cellule de mémoire dite "effacée" mais décalée vers la courbe caractéristique d'une cellule de mémoire dite "programmée",
**caractérisé en ce qu** il comprend les étapes suivantes consistant à :
(a) choisir, en tant que cellule de vérification (Cveri), au moins une première cellule dans l'état d'effacement de la mémoire (10) et positionner sa courbe caractéristique (VERI1g, VERI1d, VERI2d) entre celle de la cellule de référence et celle d'une cellule "programmée",
(b) sélectionner simultanément à la lecture une cellule de référence (Cref) et la cellule de vérification (Cveri),
(c) comparer les signaux provenant de ladite cellule de référence (Cref) et de ladite cellule de vérification (Cveri) lus lors de l'étape (b),
(d) fournir un signal de rafraîchissement (Sr1, Sr2, Sr3) de la cellule (6) de référence (Cref) lorsque le signal lu sur cette dernière est inférieur au signal lu sur la cellule de vérification (Cveri).

2. Procédé selon la revendication 1, **caractérisé en ce qu'**il comprend, en outre, l'étape suivante consistant à :
(e) retourner à l'étape (b) pour une autre cellule de référence.

3. Procédé selon la revendication 1 ou 2, **caractérisé en ce que** le signal de rafraîchissement (Sr1, RE) commande un effacement de la cellule de référence sélectionnée.

4. Procédé selon la revendication 1 ou 2, **caractérisé en ce que** le signal de rafraîchissement (Sr2, RE) commande l'application d'une tension de décalage de la cellule de référence sélectionnée.

5. Procédé selon la revendication 1 ou 2, **caractérisé en ce que** le signal de rafraîchissement (Sr3) commande une modification de gain de l'amplificateur de lecture commun (26ref) à toutes les cellules de référence et **en ce que** le signal de rafraîchissement n'est élaboré que si toutes les cellules de référence (Cref) ont fourni un signal inférieur au signal lu sur la cellule de vérification (Cveri).

6. Procédé selon l'une des revendications précédentes, **caractérisé en ce qu'**il est appliqué en outre pour rafraîchir la ou les cellules de vérification (Cveri) en choisissant une deuxième cellule de vérification, par les étapes suivantes consistant à :
(a) choisir, en tant que cellule de vérification (Cveri), au moins une deuxième cellule dans l'état d'effacement de la mémoire (10) et positionner sa courbe caractéristique (VERI1g, VERI1d, VERI2d) entre celle de la cellule de référence et celle d'une cellule "programmée",
(b) sélectionner simultanément à la lecture une cellule de référence (Cref) et ladite deuxième cellule de vérification (Cveri),
(c) comparer les signaux provenant de ladite cellule de référence (Cref) et de ladite cellule de vérification (Cveri) lus lors de l'étape (b),
(d) fournir un signal de rafraîchissement (Sr1, Sr2, Sr3) de la cellule (6) de référence (Cref) lorsque le signal lu sur cette dernière est inférieur au signal lu sur ladite deuxième cellule de vérification (Cveri).

7. Dispositif de rafraîchissement d'au moins une cellule de mémoire de référence (Cref) dans une mémoire de type non volatile, ladite cellule de référence (Cref) présentant une courbe caractéristique (A, A') qui correspond à une courbe caractéristique d'une cellule de mémoire dite "effacée" mais décalée vers la courbe caractéristique d'une cellule de mémoire dite "programmée",
**caractérisé en ce qu'**il comprend :
- des moyens (12, 14, 16, 18) pour choisir, en tant que cellule de vérification (Cveri), une cellule de mémoire dans l'état d'effacement et la positionner selon une courbe caractéristique (VERI1g, VERI1d, VERI2d) entre celle de la cellule de référence et celle d'une cellule programmée,
- des moyens pour sélectionner (VERI, 30) simultanément à la lecture une cellule de référence (Cref) et la cellule de vérification,
- des moyens (22, 28, 30) pour comparer les signaux lus sur la cellule de référence (Cref) et sur la cellule de vérification (Cveri), et fournir un signal de rafraîchissement (Sr1, Sr2, Sr3) lorsque le signal lu sur la cellule de référence est inférieur au signal lu sur la cellule de vérification, et
- des moyens pour modifier, en présence du signal de rafraîchissement (Sr1, Sr2, Sr3), la courbe caractéristique de la cellule de référence (Cref) afin de la remettre dans un état proche de l'état initial.

8. Dispositif selon la revendication 7, **caractérisé en ce que** les moyens de modification de la courbe caractéristique comprennent des moyens de sélection (RE) en vue de l'effacement de ladite cellule de référence.

9. Dispositif selon la revendication 7, **caractérisé en ce que** les moyens de modification de la courbe caractéristique comprennent des moyens de décalage (RE) en tension de la cellule de référence sélectionnée.

10. Dispositif selon la revendication 7, **caractérisé en ce que** les moyens de modification de la courbe caractéristique de la cellule de référence comprennent des moyens de modification du gain de l'amplificateur de lecture (26ref) commun à toutes les cellules de référence.

11. Dispositif selon l'une des revendications 7 à 10, **caractérisé en ce que** les moyens pour comparer les signaux lus sur la cellule de référence (Cref) et la cellule de vérification (Cveri) comprennent un comparateur (22) à deux bornes d'entrée et un commutateur (30) à deux états, un premier état pour comparer les signaux lus sur une cellule de mémoire (CE) et une cellule de référence (Cref) et un deuxième état pour comparer les signaux lus sur une cellule de référence et une cellule de vérification (Cveri).

## Claims

1. Method for refreshing at least one reference memory cell (Cref) in a memory (10) of the non-volatile type, said reference cell (Cref) having a characteristic curve (A, A') corresponding to a characteristic curve of a memory cell called "erased" but shifted towards a characteristic curve of a memory cell called "programmed",
**characterized in that** it comprises the following steps consisting in:
(a) selecting, as a checking cell (Cveri) at least one first cell in the erased state of the memory (10) and positioning the characteristic curve (VERI1g, VERI1d, VERI2d) thereof between the characteristic curve of the reference cell and that of a "programmed" cell,
(b) simultaneously selecting for reading one reference cell (Cref) and the checking cell (Cveri),
(c) comparing the signals from said reference cell (Cref) and from said checking cell (Cveri) read during step (b),
(d) supplying a refresh signal (Sr1, Sr2, Sr3) of the reference cell (Cref) when the signal read on the latter is less than the signal read on the checking cell (Cveri).

2. Method according to claim 1, **characterized in that** it further comprises the following step consisting in:
(e) going back to step (b) for another reference cell.

3. Method according to claim 1 or 2, **characterized in that** the refresh signal (Sr1, RE) commands erasing the selected reference cell.

4. Method according to claim 1 or 2, **characterized in that** the refresh signal (Sr2, RE) commands applying a voltage for shifting the selected reference cell.

5. Method according to claim 1 or 2, **characterized in that** the refresh signal (Sr3) commands modifying the gain of the readout amplifier (26ref) common to all the reference cells and **in that** the refresh signal is elaborated only if all the reference cells (Cref) have supplied a signal less than the signal readout on the checking cell (Cveri).

6. Method according to any of the preceding claims, **characterized in that** it is further applied for refreshing the checking cell or cells (Cveri) by selecting a second checking cell by the following steps consisting in:
(a) selecting as checking cell (Cveri), at least a second cell in the erased state of the memory (10) and positioning its characteristic curve (VERI1g, VERI1d, VERI2d) between the characteristic curve of the reference cell and that of a "programmed" cell,
(b) simultaneously selecting for reading one reference cell (Cref) and said second checking cell (Cveri),
(c) comparing the signals from said reference cell (Cref) and said checking cell (Cveri) read during step (b),
(d) supplying a refresh signal (Sr1, Sr2, Sr3) for refreshing the reference cell (Cref) when the signal read on the latter is less than the signal read on said second checking cell (Cveri).

7. Device for refreshing at least one reference memory cell (Cref) in a memory of the non-volatile type, said reference Cell (Cref) having a characteristic curve (A, A') which corresponds to a characteristic curve of a memory cell called "erased" but shifted towards the characteristic curve of a memory cell called "programmed",
**characterized in that** it comprises:
- means (12, 14, 16, 18) for selecting as checking cell (Cveri) a memory cell in the erased state and positioning it according to a characteristic curve (VERI1g, VERI1d, VERI2d) between the characteristic curve of the reference cell and that of a programmed cell,
- selecting means (VERI, 30) for simultaneously selecting for reading one reference cell (Cref) and the checking cell,
- comparing means (22, 28, 30) for comparing the signals read on the reference cell (Cref) and on the checking cell (Cveri) and supplying a refresh signal (Sr1, Sr2, Sr3) when the signal read on the reference cell is less than the signal read on the checking cell, and
- modifying means for modifying, in the presence of the refresh signal (Sr1, Sr2, Sr3), the characteristic curve of the reference cell (Cref) in order to put it back in a state near the initial state.

8. Device according to claim 7, **characterized in that** the modifying means for modifying the characteristic curve comprise selection means (RE) in view of erasing said reference cell.

9. Device according to claim 7, **characterized in that** the modifying means for modifying the characteristic curve comprise shifting means (RE) for shifting the voltage of the selected reference cell.

10. Device according to claim 7, **characterized in that** the modifying means for modifying the characteristic curve of the reference cell comprise means for modifying the gain of the readout amplifier (26ref) common to all the reference cells.

11. Device according to any of claims 7 to 10, **characterized in that** the comparing means for comparing the signals read on the reference cell (Cref) and on the checking cell (Cveri) comprise a comparator (22) having to input terminals and a switch (30) having two states, a first state for comparing the signals read on a memory cell (CE) and on a reference cell (Cref) and a second state for comparing the signals read on a reference cell and on a checking cell (Cveri).

## Patentansprüche

1. Verfahren zum Auffrischen zumindest einer Referenzspeicherzelle (Cref) in einem nichtflüchtigen Speicher (10), wobei die Referenzzelle (Cref) eine Kennlinie (A, A') aufweist, die einer Kennlinie einer sogenannten "gelöschten" Speicherzelle entspricht, jedoch zu der Kennlinie einer sogenannten "programmierten" Speicherzelle hin verschoben ist,
**dadurch gekennzeichnet, dass** es die folgenden Schritte umfasst:
(a) Auswählen zumindest einer ersten Zelle als Prüfzelle (Cveri) im Löschzustand des Speichers (10) und Positionieren ihrer Kennlinie (VERl1g, VERI1d, VERI2d) zwischen die der Referenzzelle und die einer "programmierten" Zelle,
(b) gleichzeitiges Auslesen einer Referenzzelle (Cref) und der Prüfzelle (Cveri),
(c) Vergleichen der in Schritt (b) ausgelesenen Signale aus der Referenzzelle (Cref) und der Prüfzelle (Cveri),
(d) Ausgeben eines Signals (Sr1, Sr2, Sr3) zum Auffrischen der Referenzzelle (6) (Cref), wenn das aus letzterer ausgelesene Signal geringer als das aus der Prüfzelle (Cveri) ausgelesene Signal ist.

2. Verfahren nach Anspruch 1, **dadurch gekennzeichnet, dass** es ferner den folgenden Schritt umfasst:
(e) Zurückkehren zu Schritt (b) für eine weitere Referenzzelle.

3. Verfahren nach Anspruch 1 oder 2, **dadurch gekennzeichnet, dass** das Auffrischungssignal (Sr1, RE) ein Löschen der ausgewählten Referenzzelle steuert.

4. Verfahren nach Anspruch 1 oder 2, **dadurch gekennzeichnet, dass** das Auffrischungssignal (Sr2, RE) das Anlegen einer Spannung zum Verschieben der ausgewählten Referenzzelle steuert.

5. Verfahren nach Anspruch 1 oder 2, **dadurch gekennzeichnet, dass** das Auffrischungssignal (Sr3) eine Leistungsänderung des Leseverstärkers (26ref) steuert, der sämtlichen Referenzzellen gemein ist, und dass das Auffrischungssignal nur dann verarbeitet wird, wenn sämtliche Referenzzellen (Cref) ein Signal ausgegeben haben, das geringer ist als das aus der Prüfzelle (Cveri) ausgelesene Signal.

6. Verfahren nach einem der vorangehenden Ansprüche, **dadurch gekennzeichnet, dass** es ferner zum Auffrischen von der bzw. den Prüfzellen (Cveri) angewendet wird, indem eine zweite Prüfzelle durch die nachfolgenden Schritte gewählt wird:
(a) Auswählen zumindest einer zweiten Zelle als Prüfzelle (Cveri) im Löschzustand des Speichers (10) und Positionieren ihrer Kennlinie (VERI1g, VERI1d, VERI2d) zwischen die der Referenzzelle und die einer "programmierten" Zelle,
(b) gleichzeitiges Auslesen einer Referenzzelle (Cref) und der zweiten Prüfzelle (Cveri),
(c) Vergleichen der in Schritt (b) ausgelesenen Signale aus der Referenzzelle (Cref) und der Prüfzelle (Cveri),
(d) Ausgeben eines Signals (Sr1, Sr2, Sr3) zum Auffrischen der Referenzzelle (6) (Cref), wenn das aus letzterer ausgelesene Signal geringer als das aus der zweiten Prüfzelle (Cveri) ausgelesene Signal ist.

7. Vorrichtung zum Auffrischen zumindest einer Referenzspeicherzelle (Cref) in einem nichtflüchtigen Speicher, wobei die Referenzzelle (Cref) eine Kennlinie (A, A') aufweist, die einer Kennlinie einer sogenannten "gelöschten" Speicherzelle entspricht, jedoch zu der Kennlinie einer sogenannten "programmierten" Speicherzelle hin verschoben ist,
**dadurch gekennzeichnet, dass** sie aufweist:
- Mittel (12, 14, 16, 18) zum Auswählen zumindest einer Speicherzelle als Prüfzelle (Cveri) im Löschzustand und zum Positionieren derselben gemäß einer Kennlinie (VERl1g, VERI1d, VERI2d) zwischen die der Referenzzelle und die einer programmierten Zelle,
- Mittel (VERI, 30) zum gleichzeitigen Auslesen einer Referenzzelle (Cref) und der Prüfzelle,
- Mittel (22, 28, 30) zum Vergleichen der aus der Referenzzelle (Cref) und der Prüfzelle (Cveri) ausgelesenen Signale und zum Ausgeben eines Auffrischungssignals (Sr1, Sr2, Sr3), wenn das aus der Referenzzelle ausgelesene Signal geringer als das aus der Prüfzelle ausgelesene Signal ist, und
- Mittel, um bei Vorhandensein des Auffrischungssignals (Sr1, Sr2, Sr3) die Kennlinie der Referenzzelle (Cref) zu ändern, um sie wieder in einen dem Ausgangszustand nahe liegenden Zustand zu versetzen.

8. Vorrichtung nach Anspruch 7, **dadurch gekennzeichnet, dass** die Mittel zum Ändern der Kennlinie Auswählmittel (RE) zwecks Löschung der Referenzzelle aufweisen.

9. Vorrichtung nach Anspruch 7, **dadurch gekennzeichnet, dass** die Mittel zum Ändern der Kennlinie Mittel (RE) zum Verschieben der Spannung der ausgewählten Referenzzelle aufweisen.

10. Vorrichtung nach Anspruch 7, **dadurch gekennzeichnet, dass** die Mittel zum Ändern der Kennlinie der Referenzzelle Mittel zur Leistungsänderung des Leseverstärkers (26ref) aufweisen, der sämtlichen Referenzzellen gemein ist.

11. Vorrichtung nach einem der Ansprüche 7 bis 10, **dadurch gekennzeichnet, dass** die Mittel zum Vergleichen der aus der Referenzzelle (Cref) und aus der Prüfzelle (Cveri) ausgelesenen Signale einen Komparator (22) mit zwei Eingangsanschlüssen und einen Schalter (30) mit zwei Zuständen aufweisen, nämlich einen ersten Zustand zum Vergleichen der aus einer Speicherzelle (CE) und einer Referenzzelle (Cref) ausgelesenen Signale und einen zweiten Zustand zum Vergleichen der aus einer Referenzelle und einer Prüfzelle (Cveri) ausgelesenen Signale.
